Europäisches Patentamt

European Patent Office

Office européen des brevets

(19)

(11) EP 0 602 394 B1

(12) **EUROPÄISCHE PATENTSCHRIFT**

(45) Veröffentlichungstag und Bekanntmachung des Hinweises auf die Patenterteilung:
**06.08.1997 Patentblatt 1997/32**

(51) Int Cl.⁶: **H03D 7/16**, H03D 3/00

(21) Anmeldenummer: **93118370.1**

(22) Anmeldetag: **12.11.1993**

(54) **Verfahren und Vorrichtung zur Korrektur der Phasen- und Amplitudenfehler bei direktmischenden Empfangseinrichtungen**

Method and device for the correction of phase and amplitude errors for direct conversion receiving devices

Procédé et dispositif de correction des erreurs de phase et d'amplitude pour des dispositifs récepteurs à conversion directe

(84) Benannte Vertragsstaaten:
**AT BE CH DE DK ES FR GB GR IE IT LI LU MC NL PT SE**

(30) Priorität: **14.11.1992 DE 4238543**

(43) Veröffentlichungstag der Anmeldung:
**22.06.1994 Patentblatt 1994/25**

(73) Patentinhaber: **Hagenuk Telecom GmbH 24118 Kiel (DE)**

(72) Erfinder:
• **Kluge, Wolfram**
  **D-01309 Dresden (DE)**

• **Jehring, Frieder**
  **D-01189 Dresden (DE)**
• **Krause, Frank Michael**
  **D-01069 Dresden (DE)**

(74) Vertreter: **Hansmann, Dierk, Dipl.-Ing. et al Patentanwälte Hansmann-Klickow-Hansmann Jessenstrasse 4 22767 Hamburg (DE)**

(56) Entgegenhaltungen:
**EP-A- 0 180 339       EP-A- 0 343 273**
**DE-A- 3 938 643       DE-A- 3 938 671**

**Beschreibung**

Die Erfindung betrifft ein Verfahren und eine Vorrichtung zur Korrektur von Empfangssignalen bei direktmischenden Empfangssystemen zum Kompensieren von Amplituden- und Phasenfehlern.

Bei Direct-Conversion-Empfängern, die gelegentlich auch als Homodynempfänger oder Null-ZF-Empfänger bezeichnet werden, wird das empfangene, winkelmodulierte Hochfrequenzsignal (HF-Signal) mit dem Signal eines lokalen Oszillators (LO) gemischt, dessen Frequenz näherungsweise der Trägerfrequenz des HF-Signals entspricht. Da das LO-Signal ungefähr die gleiche Frequenz aufweist wie das HF-Signal, entsteht nach der Mischung ein Zwischenfrequenzsignal (ZF-Signal), das im niederfrequenten Bereich (NF-Bereich) liegt. Mathematisch gesehen entstehen bei der Mischung zeitweise negative Frequenzen, die aber in der Praxis nicht von den positiven Frequenzen unterschieden werden können. Zur Aufrechterhaltung der vollen Information ist es bei Direct-Conversion-Empfängern notwendig, zwei um 90° zueinander verschobene ZF-Signale zu bilden. Dazu sind zwei Mischer vorhanden, an die das HF-Signal und das LO-Signal angelegt werden, wobei das an die eine Mischstufe angelegte HF- oder LO-Signal gegenüber dem entsprechenden, an die andere Mischstufe angelegten, Signal um 90° phasenverschoben ist. Die eine Mischstufe, vor der keine Phasenverschiebung folgt, erzeugt ein erstes ZF-Signal, das als in-phase-Signal (I) bezeichnet wird. An dem zweiten Mischer wird ein zweites ZF-Signal erzeugt, das zum ersten ZF-Signal um 90° phasenverschoben ist und das als Quadratursignal (Q) bezeichnet wird. Die beiden ZF-Signale (I), (Q), werden über jeweils ein Tiefpaßfilter zur Selektion eines Empfangskanals und einen ZF-Verstärker geführt. Die verstärkten und gefilterten Signale können einem Demodulator zugeführt werden. Da die ZF-Signale im NF-Bereich liegen, werden an den ZF-Verstärker keine hohen Anforderungen gestellt und es besteht die Möglichkeit, ZF-Filter sowie Demodulator nach Analog-Digital-Wandlung der ZF-Signale in einem Rechenwerk digital zu realisieren. Hierzu bieten sich digitale Signalprozessoren als kostengünstige Lösung an. Insbesondere ist die Verwendung von Festkommarechnern angestrebt. Gegenüber herkömmlichen Super-Heterodynempfängern haben Direct-Conversion-Empfänger den Vorteil, daß das Problem der Spiegelfrequenzunterdrückung nicht auftritt und daher keine schmalbandigen HF-Filter für die Vorselektion vor dem Mischer und für die ZF-Signale benötigt werden. Direct-Conversion-Empfänger sind deshalb für eine vollständige integrierte Lösung geeignet.

Trotz dieser Vorteile ist bis heute das Konzept das Direct-Conversion-Empfängers in keinem nennenswerten Umfang eingesetzt worden. Ein Grund dafür ist, daß durch Toleranzen in den Funktionsgruppen des Empfängers Abweichungen in der Phase beziehungsweise in der Phasenverschiebung zwischen den ZF-Signalen (Phasenfehler) sowie Abweichungen in der Amplitudengleichheit der ZF-Signale (Amplitudenfehler) entstehen, die zu einer drastischen Erhöhung des Klirrfaktors bei der Demodulation führen. Ein weiterer Grund ist, daß Signale mit der Frequenz 0 (Gleichanteile) mit zum ZF-Spektrum gehören. Daher stellt jeder Gleichspannungsoffset in den ZF-Kanälen eine Störfrequenz im Empfangsband dar, deren Auswirkungen sich prinzipiell nicht beseitigen sondern nur verringern lassen. Gleichsspannungsoffsets entstehen aber nahezu unvermeidlich in den Mischern durch Übersprechen der HF-Signale an den Mischereingängen, bei großen Empfangssignalen durch Multiplikation mit sich selbst an der nichtlinearen Mischereingangskennlinie und durch Bauelementetoleranzen als statische Größe im Mischer sowie im ZF-Verstärker. Die Gleichsspannungsoffsets können unter Umständen wesentlich größer sein als das DC-Nutzsignal. Der DC-Offset wird üblicherweise mittels eines Hochpasses (AC-Kopplung) abgetrennt. Hierbei geht jedoch auch das DC-Nutzsignal verloren, was zu einer Erhöhung des Klirrfaktors führt.

Eine technische Lösung für die bei Direct-Conversion-Empfängern entstehenden Fehler ist es, das Auftreten solcher Fehler möglichst zu vermeiden, indem besonders sorgfältig ausgewählte Bauelemente eingesetzt werden. Dies ist aber mit erheblichem Aufwand verbunden.

Andererseits könnte ein technischer Lösungsansatz darin bestehen, die Fehler nicht zu groß werden zu lassen und zum Beispiel in einem Regelwerk auszugleichen.

In DE 39 38 671 A1 wird versucht, eine Korrektur der Amplituden- und Phasenfehler durch die Bildung von aus den I- und Q-Signalen abgeleiteten Signalen (IK, QK) zu erreichen. IK ist im wesentlichen das Produkt aus dem ursprünglichen I- und Q-Signal und QK ist im wesentlichen die Differenz der Quadrate der ursprünglichen Q- und I-Signale. Die so berechneten Signale IK und QK sind um 90° phasenverschobenene Signale, die in Amplitude und Phase besser übereinstimmen als die unkorrigierten Signale I und Q. Dies gilt aber nur näherungsweise für kleine Amplituden- und Phasenfehler. In der genannten Schrift wird ausdrücklich darauf hingewiesen, daß die Fehlerkorrektur umso besser ist, je kleiner die Fehler vor der Korrektur sind. Bei großen Fehlern vor der Korrektur reicht die mit dem geschilderten Verfahren erreichbare Korrektur nicht aus. Bei für den HF-Teil realistischen Fehlergrößen von 3 dB für den Amplitudenfehler und 10° für den Phasenfehler bleiben nach der Korrektur immer noch 0,39 dB und 3,35° übrig. Dies führt bei den hier beabsichtigten Anwendungen zu nicht vertretbaren Klirrfaktoren. Außerdem entsteht bei der Berechnung der abgeleiteten Signale IK und QK eine Frequenzverdopplung. In der genannten Schrift wird diese Frequenzverdopplung für vertretbar gehalten. Die Erhöhung der Frequenz macht jedoch auch eine Erhöhung der Abtastfrequenz erforderlich, so daß, wenn alle Operationen zur Berechnung der korrigierten Signale in einem digitalen Signalprozessor durchgeführt werden sollen, dessen Rechenleistung mindestens verdoppelt werden muß. Dies führt zu einem erheblichen Mehraufwand.

Nach EP 0 180 339 A2 ist ein direct-conversion Sender bzw. Empfänger bekannt, bei dem DC-Offsets, Amplituden- und Phasenfehler korrigiert werden. Die Korrektur von Amplituden- und Phasenfehler ist nur möglich, wenn die DC-Offsets beseitigt sind. Für die Korrektur des Amplitudenfehlers ist eine Vorwärtskorrektur vorgesehen, bei der aus langfristigen Mittelwerten von gleichgerichteten I- und Q-Signalen ein Quotient als Korrekturfaktor gebildet wird. Der phasenfehler wird mit einer Regelung korrigiert. Bei einer derartigen Anordnung ist nachteilig, daß die Korrektur nur nach Beseitigung der DC-Offsets möglich ist, daß die Korrektur von Amplituden- und Phasenfehler nach verschiedenen Verfahren erfolgt und daß der Phasenfehler mit einer Regelung korrigiert wird. Die unterschiedlichen Korrekturverfahren weisen unterschiedliche Zeitverhalten auf. Die Korrekturverfahren sind miteinander gekoppelt. Damit liegt letztlich nur äußerst selten (zufällig) ein Signal vor, bei dem sowohl Amplituden- als auch Phasenfehler ausgeglichen sind. Die für die Korrektur des Phasenfehlers vorgeschlagene Regelung ist mit den bekannten Instabilitäten verbunden. Es kann zum Überschwingen oder sogar zu Resonanzen kommen. Zur Regelung wird entweder die Bildung eines Mittelwertes des Produktes aus I- und Q-Signal vorgeschlagen, wobei große Amplituden auftreten können, was mit rechentechnischen Schwierigkeiten verbunden sein kann, oder es wird die Detektion des Nulldurchgang der I- und Q-Signale vorgesehen, wobei eine nicht triviale Interpolation, aber auch die Erkennung der Rotationsrichtung erforderlich wird, was mit weiterem rechentechnischen Aufwand verbunden ist.

Aufgabe der Erfindung war es daher, ein Verfahren und eine Vorrichtung zur Korrektur von empfangenen Signalen bei direktmischenden Empfangssystemen anzugeben, die die Kompensation von Amplituden- und Phasenfehlern auch bei größeren Fehlerwerten unter Verwendung möglichst einfacher Prozessoren, insbesondere möglichst einfacher digitaler Signalprozessoren, erlaubt.

Außerdem soll die Korrektur von Amplituden- und Phasenfehler ohne eine Regelung ausschließlich als Vorwärtskorrektur erfolgen und beide Korrekturen sollen mit gleichem Zeitverhalten unabhängig voneinander (entkoppelt) durchgeführt werden.

Die Lösung dieser Aufgabe erfolgt durch ein Verfahren nach dem Patentanspruch 1 beziehungsweise durch eine Vorrichtung nach dem Patentanspruch 6.

Erfindungsgemäß wird nach Bildung der ZF-Signale I und Q eines dieser beiden ZF-Signale mit einem Korrekturfaktor K1 multipliziert, wodurch der Amplitudenfehler kompensiert wird. Aus dem unkorrigierten ZF-Signal und dem amplitudenkorrigierten ZF-Signal wird die Summe (I') beziehungsweise die Differenz (Q') gebildet. Eins der Signale I' und Q' wird mit einem zweiten Korrekturfaktor K2 multipliziert, wodurch die Signale I' und Q' auf gleiche Amplitude gebracht werden. Auf diese Weise wird der in einem Amplitudenfehler bezüglich I' und Q' transformierte Phasenfehler korrigiert. Die nach der zweiten Multiplikation vorliegenden Signale IK und QK sind in ihrer Phase um 45° bezüglich der Signale I und Q verschoben und in der Amplitude um den Faktor $\sqrt{2}$ größer, sofern keine Fehler korrigiert wurden. Beide Werte, Phasenverschiebung und Amplitudenfaktor, ändern sich mit dem Auftreten von Phasen- beziehungsweise Amplitudenfehlern. Diese Veränderungen in den Signalen IK und QK sind jedoch bei einer nachfolgenden FM-Demodulation ohne Bedeutung.

Fehlerfreie I- und Q-Signale bilden bei der Darstellung im kartesischen Koordinatensystem einen Kreis in Mittelpunktslage. Der Amplitudenfehler bewirkt ein Strecken oder Stauchen des Kreises in Achsenrichtung. Ein Phasenfehler bewirkt, daß der Kreis bezüglich einer 45°-Geraden gestaucht beziehungsweise gestreckt wird. In beiden Fällen wird der Kreis zur Ellipse verformt. Eine Verlagerung der Ellipse aus dem Ursprung wird durch Gleichspannungsoffsets hervorgerufen. Bei dem erfindungsgemäßen Verfahren wird davon ausgegangen, daß eine Korrektur von Amplituden- und Phasenfehlern unabhängig von Gleichsspannungs-Offsets erfolgen soll. Mit dem ersten Korrekturfaktor erfolgt der Ausgleich des Amplitudenfehlers. Nach der Korrektur des Amplitudenfehlers hat die Ellipse immer eine Hauptachse, die im Winkel von 45° zu den Achsen des Koordinatensystems steht. Dies ist darauf zurückzuführen, daß bei der Korrektur die Spitzenwerte in I- und Q-Richtung aneinander angeglichen werden. Anschließend erfolgt die Bildung der Summen- und Differenzsignale, welches einer Drehung der Ellipse um 45° entspricht, da die Summen- beziehungsweise Differenzbildung einer Multiplikation der I- und Q-Signale mit der Transformationsmatrix nach Gleichung 1 entspricht.

$$T = \begin{bmatrix} \cos\ (a) & \sin\ (a) \\ -\sin\ (a) & \cos\ (a) \end{bmatrix} \quad (1)$$

$$\begin{pmatrix} I' \\ Q' \end{pmatrix} = T * \begin{pmatrix} I \\ Q \end{pmatrix}$$

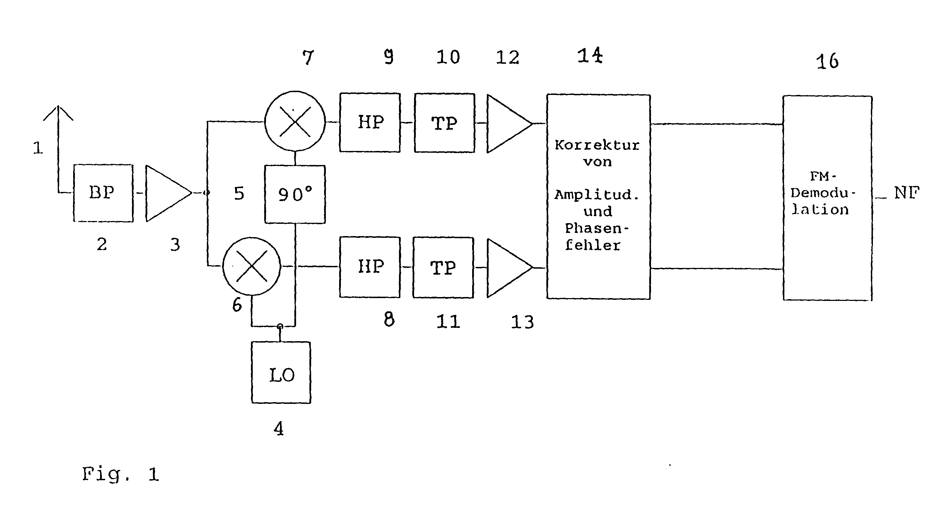

Die Ellipse der Signale I' und Q' liegt daher so im neuen Koordinatensystem, daß deren Hauptachse parallel zu einer Achsen des Koordinatensystems steht. Diese Ellipse enthält nur noch einen Amplitudenfehler bezüglich I' und Q', der von dem Phasenfehler des I- und Q-Signals herrührt. Dieser kann auf die gleiche Weise korrigiert werden wie bei den I- und Q-Signalen, also mittels eines Korrektorfaktors K2 ausgeglichen werden. Einzelheiten der Erfindung und besondere Ausführungen werden anhand der Figuren 1 bis 4 erläutert.

Es zeigen:

Fig. 1    ein Blockschaltbild eines Direct-Conversion-Empfängers;
Fig. 2    ein Ausführungsbeispiel für das Verfahren zur Korrektur von Amplituden- und Phasenfehlern;
Fig. 3    ein Ausführungsbeispiel für die Bestimmung der Korrekturfaktoren zur Verwendung für das Verfahren nach Fig. 2;
Fig. 4    eine schematische Darstellung der Kompensation von Amplituden- und Phasenfehlern zur Bildung der korrigierten Signale IK, QK aus verzerrten Eingangsgrößen I, K;
Fig. 5    ein Ausführungsbeispiel für die Bestimmung der Korrekturfaktoren mit verminderter Welligkeit zur Verwendung für das Verfahren nach Fig. 2, wobei das Vorzeichen des NF-Signals verwendet wird;
Fig. 6    ein Ausführungsbeispiel entsprechend Fig. 5, jedoch ohne das Vorzeichen des NF-Signals auskommend.

Fig. 1 zeigt die Verwendung des erfindungsgemäßen Verfahrens beziehungsweise der Vorrichtung in einem Direct-Conversion-Empfänger. Das von der Antenne 1 empfangene HF-Signal durchläuft ein Eingangsfilter 2 und wird vom Vorverstärker 3 verstärkt. Durch das Mischerpaar 6, 7 wird das HF-Signal direkt in das Basisband umgesetzt. Die Mischer 6, 7 werden von einem Signal des lokalen Oszillators 4 (LO-Signal) angesteuert, wobei in diesem Ausführungsbeispiel der Mischer 7 ein um 90° phasenverschobenes LO-Signal erhält. Die Frequenz des LO-Signals entspricht näherungsweise der Trägerfrequenz des zu empfangenden FM-Signals. An den Ausgängen der Mischer 6 und 7 liegen die niederfrequenten Basisbandsignale an. Die Spektren dieser Signale entsprechen dem in den niederfrequenten Bereich um die Trägerfrequenz verschobenen FM-Spektrum. Das Signal vom Mischer 6 wird als I-Signal und das dazu um 90° phasenverschobene Signal von Mischer 7 als Q-Signal bezeichnet. Die I- und Q-Signale werden weiter über Hochpässe 8, 9 zum Abtrennen von Gleichspannungsoffsets geleitet. Die folgenden Tiefpässe 10, 11 bilden das Kanalfilter des Empfängers zur Selektions eines Übertragungskanals aus dem Empfangsspektrum. In den Verstärkern 12, 13 wird der Pegel der I- und Q-Signale auf einen für die weitere Verarbeitung nötigen Wert angehoben. Besitzen die I- und Q-Signale nicht die gleiche Amplitude auf Grund von Verstärkungsunterschieden in den Basisbandkanälen (I-Kanal und Q-Kanal), so tritt ein Amplitudenfehler auf. Beträgt die Phase zwischen I- und Q-Signal nicht genau 90°, so tritt ein Phasenfehler auf. Beide Fehler bewirken bei der FM-Demodulation starke nichtlineare Verzerrungen und müssen daher vor der Demodulation korrigiert werden. Das erfindungsgemäße Korrekturverfahren und die Vorrichtung sind im Mittel 14 realisiert. Letzteres liefert an seinen Ausgängen die amplituden- und phasenkorrigierten Signale IK und QK. Mit diesen Signalen kann unmittelbar die Demodulation erfolgen.

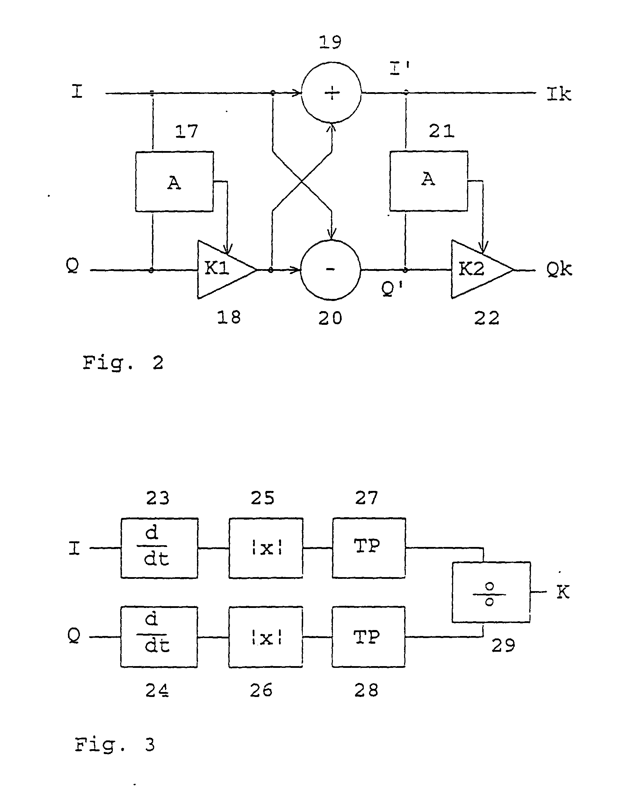

Die Arbeitsweise des Korrekturgliedes 14 wird anhand von Fig. 2 im Rahmen eines Ausführungsbeispieles beschrieben. Aus den Signalen I und Q wird im Mittel 17 ein Korrekturfaktor K1 gebildet. Mit diesem wird im Verstärker 18 im hier dargestellten Ausführungsbeispiel das Q-Signal auf die gleiche Amplitude wie das I-Signal gebracht. Wahlweise kann auch umgekehrt das I-Signal auf die gleiche Amplitude gebracht werden wie das Q-Signal. Danach ist der Amplitudenfehler beseitigt. Im weiteren wird in den Mitteln 19 und 20 die Summe I' beziehungsweise die Differenz Q' aus dem I-Signal und dem amplitudenkorrigierten Q-Signal gebildet. Aus den Signalen I' und Q' wird im Mittel 21, das vorzugsweise analog zum Mittel 17 aufgebaut ist, ein Korrekturfaktor K2 gebildet, mit dem im dargestellten Ausführungsbeispiel das Signal Q' im Verstärker 22 auf die gleiche Amplitude wie das I'-Signal gebracht wird. Damit wird der Phasenfehler als Amplitudenfehler korrigiert. Wahlweise kann auch das Signal I' an die Amplitude des Q'-Signals angepaßt werden.

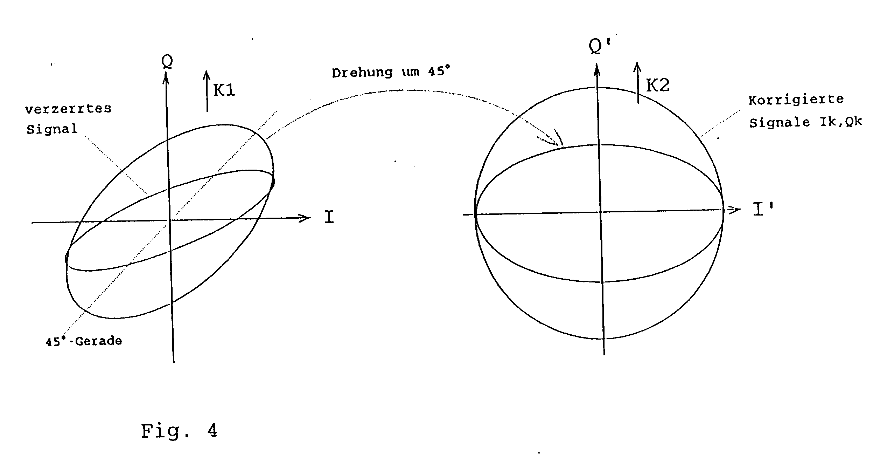

Die Bildung der Korrekturfaktoren K1 und K2 wird anhand der schematischen Darstellung eines Ausführungsbeispiels in Fig. 3 beschrieben. Die I- und Q-Signale beziehungsweise I'- und Q'-Signale werden hier einem Differentiator 23, 24 zugeführt. Hiermit werden tieffrequente Spektralanteile und Gleichspannungsoffsets unterdrückt. Außerdem können auch tieffrequente Störanteile in den I- und Q-Signalen (dynamische Mittelpunktsverschiebung) unterdrückt werden. Wenn diese nicht vorhanden sind, kann aber auch auf einen Differentiator verzichtet werden. Die gegebenenfalls differenzierten I- und Q-Signale werden in Mitteln 25, 26 einer Betragsbildung unterzogen. Mittels der Tiefpässe 27, 28 werden die in diesen Signalen enhaltenen Gleichanteile abgetrennt. Aus diesen abgetrennten Signalen wird im Mittel 29 der Quotient gebildet, der den Korrekturfaktor K1 darstellt. Wenn I und Q als Folge von Zahlenwerten durch zeitdiskrete Abtastungen der I- und Q-Signale vorliegen, können die Verfahren nach Fig. 2 beziehungsweise Fig. 3 mit unterschiedlicher Abtastrate arbeiten. Die Abtastrate des Korrekturverfahrens nach Fig. 2 wird durch das angewandte FM-Demodulationsverfahren bestimmt. Die Abtastrate des Verfahrens nach Fig. 3 richtet sich danach, wie schnell sich Amplitude und Phasenfehler ändern.

Die nach Fig. 2 bestimmten, korrigierten Signale IK und QK können unmittelbar in dem FM-Demodulator 16 (Fig. 1) demoduliert werden.

Die Demodulation kann vorteilhafterweise bei Verwendung eines digitalen Signalprozessors zusammen mit den anderen Korrekturschritten ausgeführt werden.

Mit dem erfindungsgemäßen Verfahren und der Vorrichtung können die Korrekturen von Amplituden- und Phasenfehlern schneller durchgeführt werden. Es können auch große Fehler ausgeglichen werden, so daß weder an die Bauteile der HF-Eingangsstufe noch der Mischer und NF-Stufe besondere Anforderungen zu stellen sind. Hierdurch wird erstmals die Möglichkeit eröffnet, direktmischende Empfangssysteme in größerem Umfang einzusetzen.

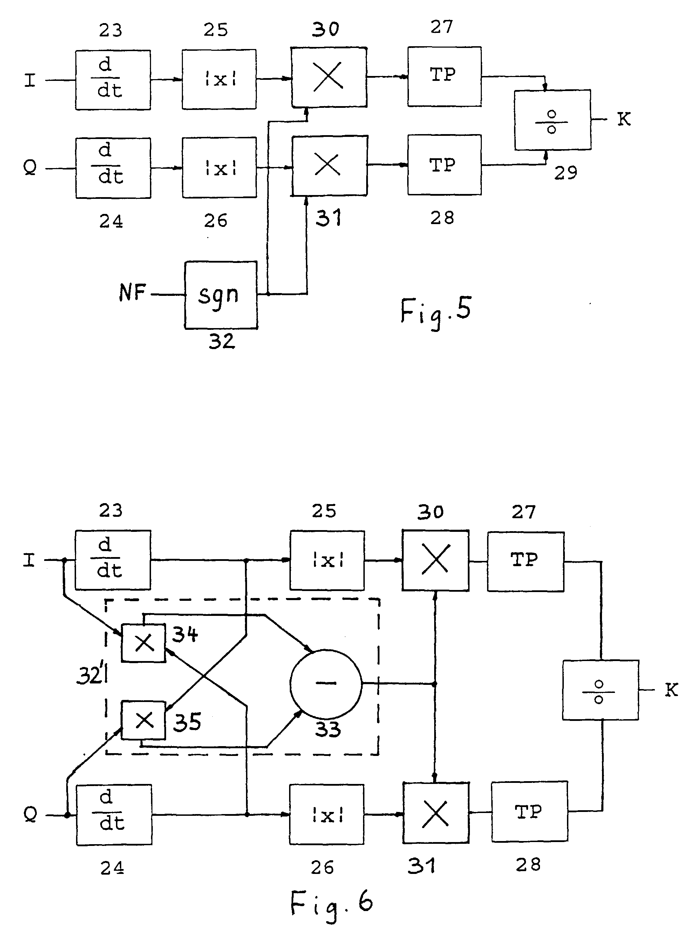

Eine weiter verbesserte Ausführung ist in Fig. 5, Fig. 6 dargestellt. Bei dieser Ausführung wird eine verringerte Welligkeit des Korrekturfaktors K erreicht.

Die Bildung der Korrekturfaktoren K1 und K2 mit verringerter Welligkeit wird anhand der schematischen Darstellung eines Ausführungsbeispiels in Fig. 5 beschrieben. Die I- und Q-Signale beziehungsweise I'- und Q'-Signale werden hier einem Differentiator 23, 24 zugeführt. Außerdem können auch tieffrequente Störanteile in den I- und Q-Signalen (dynamische Mittelpunktsverschiebungen) unterdrückt werden. Danach wird das Vorzeichensignal Vz, das aus dem Ausgangssignal des FM-Demodulators 16 in Mittel 32 (Vorzeichenbildner) durch die Signum-Funktion gebildet wird, auf den Betrag der differenzierten Signale übertragen. Diese Übertragung wird ausgeführt als Multiplikation 30, 31 mit dem Signal Vz, das nur die Werte +1 und -1 annehmen kann. Mit Hilfe der Tiefpässe 27 und 28 werden die Gleichanteile aus den Signalen gewonnen. Aus diesen Gleichanteilen wird in Mittel 29 der Quotient gebildet, der den Korrekturfaktor K1 darstellt.

Da die Verzerrungen des Ausgangssignals des FM-Demodulators 16, die durch den Amplituden- und den Phasenfehler hervorgerufen werden, nicht dessen Polarität beeinflussen, ist es möglich, das Vorzeichen des Ausgangssignals des Demodulators für die Bestimmung der Korrekturfaktoren zu verwenden. Steht das Ausgangssignal des Demodulators nicht zur Verfügung, so kann es in einem zusätzlichen Mittel 32' (Fig. 6) für zeitkontinuierliche Systeme nach der Vorschrift

$$V'_z(t) = I(t) \frac{dQ(t)}{dt} - Q(t) \frac{dI(t)}{dt}$$

gebildet werden. Dabei besteht das Mittel 32' aus geeignet verbundenen Multiplikatoren 34, 35 und Subtrahierer 33.

Für zeitdiskrete Systeme kann das Vorzeichen nach der Vorschrift

$$V'z(k) = I(k)\,Q(k-1) - I(k-1)\,Q(k)$$

gebildet werden.

Die Anwendung der Mittel 23, 24, 30, 31 und 32, 32' verringert die Welligkeit des Korrekturfaktors K. Bei gleicher Anforderung an die Genauigkeit des Korrekturfaktors K kann bei Verwendung der angegebenen Mittel die Grenzfrequenz der Tiefpässe erhöht werden, wodurch sich die Reaktionszeit des Verfahrens auf Änderungen des Amplitudenfehlers verringert.

Für die Funktion des Verfahrens nach Fig. 3 ohne die Mittel 23, 24, 30, 31 und 32, 32' wird gefordert, daß die I- und Q-Signale ohne einen Amplitudenfehler den gleichen arithmetischen Mittelwert aufweisen. Für frequenzmodulierte I- und Q-Signale ist diese Bedingung nur erfüllt, wenn das Quellsignal der Modulation (z.B. ein Sprachsignal) als mittelwertfreier, stochastischer Prozeß aufgefaßt werden kann. Dazu ist jedoch ein Beobachtungszeitraum notwendig, der wesentlich länger als die Dauer der Autokorrelationsfunktion des modulierenden Prozesses ist. Im einzelnen verursachen bestimmte Frequenzen des Modulationssignals, die mit der Trägerfrequenz korreliert sind (und damit eine Synchronität aufweisen), Abweichungen des ermittelten Korrekturfaktors. Der Tiefpaß muß eine Mittelwertbildung über solche synchronen Abschnitte des Modulationssignals ausführen. Dadurch bestimmen die statistischen Eigenschaften des Modulationssignals die notwendige Dauer der Mittelwertbildung und die damit verbundene Reaktionszeit des Verfahrens auf Änderungen des zu erfassenden Amplitudenfehlers.

Ein günstigeres Verhalten zeigt das Verfahren wir in Fig. 3 dargestellt. Die statistischen Eigenschaften des Modulationssignals haben keinen Einfluß mehr auf die Welligkeit des Korrekturfaktors K. Dessen Welligkeit wird lediglich durch die Wechselanteile des I- und Q-Signals bestimmt, welche die Mittel 23, 25, 30, 27 beziehungsweise die Mittel 24, 26, 31, 28 passieren können. Eine Abhängigkeit der Synchronität zwischen der Trägerfrequenz und der Frequenz des Modulationssignals besteht nicht mehr. Der Korrekturfaktor K kann deshalb wesentlich schneller erfaßt werden.

**Patentansprüche**

1. Verfahren zum Korrigieren von Amplituden- und Phasenfehlern in einem direktmischenden Empfangssystem, in dem ein winkelmoduliertes, empfangenes, hochfrequentes Signal in zwei Mischern mit zwei um 90° phasenverschobenen LO-Signalen mit näherungsweise gleicher Frequenz zu ersten und zweiten, in Quadratur stehenden ZF-Signalen (I, Q) gemischt werden, dadurch gekennzeichnet, daß eines der beiden ZF-Signale (I, Q) zur Bildung eines amplitudenkorrigierten ZF-Signals mit einem ersten Korrekturfaktor (K1) multipliziert wird, daß Summen-(I') und Differenzsignale (Q') aus dem unkorrigierten ZF-Signal und dem amplitudenkorrigierten ZF-Signal gebildet werden, und daß entweder das Summen- (I') oder das Differenzsignal (Q') zur Bildung von phasenkorrigierten ZF-Signalen mit einem zweiten Korrekturfaktor (K2) multipliziert wird, wodurch das Summen- (I') und das Differenzsignal (Q') auf gleiche Amplitude gebracht werden.

2. Verfahren nach Anspruch 1, dadurch gekennzeichnet, daß zur Bildung des ersten Korrekturfaktors (K1)

   a) das erste und zweite ZF-Signal (I, Q) einer Betragsbildung unterworfen und
   b) aus den so erzeugten Signalen nach Tiefpaßfilterung der erste Korrekturfaktor (K1) als Quotient bestimmt wird.

3. Verfahren nach Anspruch 1 oder 2, dadurch gekennzeichnet, daß zur Bildung des zweiten Korrekturfaktors (K2)

   a) das Summen- (I') und das Differenzsignal (Q') einer Betragsbildung unterworfen und
   b) aus den so erzeugten Signalen nach Tiefpaßfilterung der zweite Korrekturfaktor (K2) als Quotient bestimmt wird.

4. Verfahren nach Anspruch 2 oder 3, dadurch gekennzeichnet, daß anstelle der ersten und zweiten ZF-Signale (I, Q) bzw. der Summen- und Differenzsignale (I', Q') deren zeitliche Ableitungen zur Berechnung der ersten bzw. zweiten Korrekturfaktoren (K1, K2) herangezogen werden.

5. Verfahren nach Anspruch 4, dadurch gekennzeichnet, daß nach der Betragsbildung der ersten und zweiten ZF-Signale (I, Q) bzw. der Summen- und Differenzsignale (I', Q') eine Multiplikation mit dem Vorzeichen des NF-Signals eines FM-Demodulators (16) erfolgt.

6. Vorrichtung zum Korrigieren von Amplituden- und Phasenfehlern (14) in einem direktmischenden Empfangssystem, in dem ein erstes und ein zweites ZF-Signal (I, Q) in bekannter Weise gebildet und verstärkt werden, dadurch gekennzeichnet, daß ein erster Verstärker (12) für das erste ZF-Signal (I) und ein zweiter Verstärker (13) für das zweite ZF-Signal (Q) mit einer ersten Einrichtung (17) zum Bestimmen eines ersten Korrekturfaktors (K1) und diese mit einer Verstärkungseinrichtung (18) zum Ausgleich der Amplituden des ersten und zweiten ZF-Signals (I, Q) verbunden ist, daß eine Einrichtung (19) zur Summenbildung mit dem Ausgang des ersten Verstärkers (12) für das erste ZF-Signal (I) und eine Einrichtung (20) zur Differenzbildung mit dem Ausgang der Verstärkungseinrichtung (18) verbunden ist, wodurch ein Summensignal (I') und ein Differenzsignal (Q') gebildet wird, und daß die das Summensignal (I') und das Differenzsignal (Q') tragenden Ausgänge der Einrichtungen (19, 20) mit einer zweiten Einrichtung (21) zur Bestimmung eines zweiten Korrekturfaktors (K2), welche im wesentlichen der ersten Einrichtung (17) entspricht, verbunden ist, und die zweite Einrichtung (21) mit einer Verstärkungseinrichtung (22) zum Ausgleich der Amplituden des Summen- (I') und Differenzsignals (Q') verbunden ist.

7. Vorrichtung nach Anspruch 6, dadurch gekennzeichnet, daß die Einrichtungen (17, 21) zur Bestimmung des ersten und zweiten Korrekturfaktors (K1, K2) Mittel (25, 26) zur Betragsbildung enthalten, welche eingangsseitig mit dem ersten und zweiten Verstärker (12, 13) für das erste und zweite ZF-Signal (I, Q) bzw. mit den Einrichtungen (19) zur Summenbildung und den Einrichtungen (20) zur Differenzbildung, sowie ausgangsseitig mit Tiefpässen (27, 28) verbunden sind, und daß die Tiefpässe (27, 28) mit einem Mittel (29) zur Bildung eines Quotienten verbunden sind.

**8.** Vorrichtung nach Anspruch 7, dadurch gekennzeichnet, daß vor den betragsbildenden Mitteln (25, 26) Differentiatoren (23, 24) angeordnet sind, welche eingangsseitig mit dem ersten und zweiten Verstärker (12, 13) für das erste und zweite ZF-Signal (I, Q) bzw. mit den Einrichtungen (19) zur Summenbildung und den Einrichtungen (20) zur Differenzbildung, sowie ausgangsseitig mit den Mitteln (25, 26) zur Betragsbildung verbunden sind.

**9.** Vorrichtung nach Anspruch 7, dadurch gekennzeichnet, daß Multiplikatoren (30, 31) angeordnet sind, die mit einem Vorzeichenbildner (32), den betragsbildenden Mitteln (25, 26) und den Tiefpässen (27, 28) verbunden sind.

## Claims

**1.** Method for correcting amplitude errors and phase errors in a direct-mixing receiving system, in which an angle-modulated, received high-frequency signal is mixed in two mixers with two 90° phase-shifted LO signals having approximately equal frequency to form first and second IF signals (I, Q) which are in quadrature, characterized in that, to form an amplitude-corrected IF signal, one of the two IF signals (I, Q) is multiplied by a first correction factor (K1) in that the sum (I') and difference signals (Q') are formed from the uncorrected IF signal and the amplitude-corrected IF signal, and in that, to form phase-corrected IF signals, either the sum signal (I') or the difference signal (Q') is multiplied by a second correction factor (K2) as a result of which the sum signal (I') and the difference signal (Q') are brought to the same amplitude.

**2.** Method according to Claim 1, characterized in that, to form the first correction factor (K1),

a) the first IF signal and second IF signal (I, Q) are subjected to an absolute-value generation and
b) the first correction factor (K1) is determined as a quotient from the signals generated in this way after low-pass filtering.

**3.** Method according to Claim 1 or 2, characterized in that, to form the second correction factor (K2),

a) the sum signal (I') and the difference signal (Q') are subjected to an absolute-value generation and
b) the second correction factor (K2) is determined as a quotient from the signals generated in this way after low-pass filtering.

**4.** Method according to Claim 2 or 3, characterized in that, instead of the first and second IF signals (I, Q) or the sum and difference signals (I', Q'), their time derivatives are used to calculate the first and second correction factors (K1, K2), respectively.

**5.** Method according to Claim 4, characterized in that after the absolute-value generation of the first and second IF signals (I, Q) or of the sum and difference signals (I', Q'), a multiplication is carried out with the sign of the AF signal of an FM demodulator (16).

**6.** Device for correcting amplitude errors and phase errors (14) in a direct-mixing receiving system, in which a first and a second IF signal (I, Q) are formed and amplified in a known manner, characterized in that a first amplifier (12) for the first IF signal (I) and a second amplifier (13) for the second IF signal (Q) are connected to a first device (17) for determining a first correction factor (K1) and the latter is connected to an amplifying device (18) for equalizing the amplitudes of the first and second IF signal (I, Q), in that a device (19) for sum generation is connected to the output of the first amplifier (12) for the first IF signal (I) and a device (20) for difference generation is connected to the output of the amplifying device (18), as a result of which a sum signal (I') and a difference signal (Q') are generated, and in that those outputs of the devices (19, 20) which carry the sum signal (I') and the difference signal (Q') are connected to a second device (21) for determining a second correction factor (K2) which essentially corresponds to the first device (17), and the second device (21) is connected to an amplifying device (22) for equalizing the amplitudes of the sum signal (I') and the difference signal (Q').

**7.** Device according to Claim 6, characterized in that the devices (17, 21) for determining the first and second correction factors (K1, K2) contain means (25, 26) for absolute-value generation, which are connected on the input side to the first and second amplifier (12, 13) for the first and second IF signal (I, Q) or to the devices (19) for sum generation and the devices (20) for difference generation, and are also connected on the output side to low-pass filters (27, 28), and in that the low-pass filters (27, 28) are connected to means (29) for generating a quotient.

8. Device according to Claim 7, characterized in that there are disposed upstream of the absolute-value generating means (25, 26) differentiators (23, 24) which are connected on the input side to the first and second amplifier (12, 13) for the first and second IF signal (I, Q) or to the devices (19) for sum generation and the devices (20) for difference generation and are also connected on the output side to the means (25, 26) for absolute-value generation.

9. Device according to Claim 7, characterized in that multipliers (30, 31) are provided which are connected to a sign-generator (32), the absolute-value generating means (25, 26) and the low-pass filters (27, 28).

**Revendications**

1. Procédé de correction des erreurs de phase et d'amplitude d'un système récepteur à conversion directe dans lequel un signal haute fréquence, modulé en phase, capté, est mélangé dans deux mélangeurs à deux signaux d'un oscillateur local, déphasés de 90°, dont la fréquence est approximativement égale à la fréquence du signal capté, les moyennes fréquences (I, Q) étant en quadrature, caractérisé par le fait qu'un des deux signaux MF (I, Q) est multiplié par un premier facteur de correction (K1) pour obtenir un signal MF corrigé en amplitude, que les signaux de somme (I') et de différence (Q') sont dérivés du signal MF non corrigé et du signal MF corrigé en amplitude et que, soit le signal de somme (I'), soit le signal de différence (Q') est multiplié par un deuxième facteur de correction (K2) afin de compenser l'amplitude des signaux de somme (I') et de différence (Q') pour obtenir des signaux MF corrigés en phase.

2. Procédé selon la revendication 1, caractérisé par la détermination du premier facteur de correction (K1) par

   a) la quantification du premier et du deuxième signal MF (I, Q) et
   b) le premier facteur de correction (K1) étant le quotient des signaux ainsi obtenus après filtrage dans un filtre passe-bas.

3. Procédé selon la revendication 1 ou 2, caractérisé par la détermination du deuxième facteur de correction (K2) par

   a) la quantification du signal de somme (I') et du signal de différence (Q') et
   b) le deuxième facteur de correction (K2) étant le quotient des signaux ainsi obtenus après filtrage dans un filtre passe-bas.

4. Procédé selon la revendication 2 ou 3, caractérisé par le calcul du premier et du deuxième facteur de correction (K1, K2) partant de la dérivée dans le temps du premier et deuxième signal MF (I,Q) ou des signaux de somme et de différence (I', Q').

5. Procédé selon revendication 4, caractérisé par une multiplication avec le signe du signal BF d'un démodulateur FM (16) après la quantification du premier et deuxième signal MF (I, Q) ou des signaux de somme et de différence (I', Q').

6. Dispositif de correction des erreurs de phase et d'amplitude (14) d'un système récepteur à conversion directe, dans lequel une premier et un deuxième signal MF (I,Q) sont générés et amplifiés de façon connue, caractérisé par le fait qu'un premier amplificateur (12) du premier signal MF (I) et un deuxième amplificateur (13) du deuxième signal MF (Q) sont reliés à un premier dispositif (17) de détermination d'un premier facteur de correction (K1), celui-ci étant relié à un dispositif d'amplification (18) de compensation des amplitudes des premier et deuxième signaux MF (I, Q), qu'un dispositif de sommation (19) est relié à la sortie du premier amplificateur (12) du premier signal MF (I) et un dispositif de différence (20) est relié avec la sortie du dispositif d'amplification (18) par lesquels sont obtenus un signal de somme (I') et un signal de différence (Q'), et que les sorties des signaux de somme (I') et de différence (Q') des dispositifs (19, 20) sont reliées à un deuxième dispositif (21) de détermination d'un deuxième facteur de correction (K2), qui correspond essentiellement au premier dispositif (17) et que le deuxième dispositif (21) est relié à un dispositif d'amplification (22) de compensation des amplitudes des signaux de somme (I') et de différence (Q').

7. Dispositif selon la revendication 6, caractérisé par le fait qu'aux dispositifs (17, 21) de détermination du premier et du deuxième facteur de correction (K1, K2) sont associé des moyens (25, 26) de quantification dont l'entrée est reliée au premier et au deuxième amplificateur (12, 13) du premier et du deuxième signal MF (I, Q), alternativement avec les dispositifs (19) de sommation et les dispositifs (20) de différentiation et dont la sortie est reliée à des filtres passe-bas (27, 28) et qu'aux filtres passe-bas (27, 28) est associé un moyen (29) de formation d'un quotient.

8. Dispositif selon la revendication 7, caractérisé par le fait qu'en amont des moyens de quantification (25, 26) sont associé des différentiateurs (23, 24), dont les entrées sont reliées aux premier et au deuxième amplificateur (12, 13) du premier et deuxième signal MF (I, Q) ou avec les dispositifs (19) de sommation et les dispositifs (20) de différentiation et dont la sortie est reliée aux moyens (25, 26) de quantification.

9. Dispositif selon la revendication 7, caractérisé par la présence de circuits de multiplication (30, 31) reliés, d'une part, à un extracteur de signe (32) et, d'autre part, aux moyens de quantification (25, 26) et aux filtres passe-bas (27, 28).

Fig. 1

Fig. 2

Fig. 3

Fig. 4

EP 0 602 394 B1

Fig.5

Fig.6